# EUROPEAN PATENT APPLICATION

(11) **EP 3 214 655 A1**
(43) Date of publication of application: **06.09.2017**
(21) Application number: 15854966.7
(22) Date of filing: 27.10.2015
(51) Int. Cl.: H01L 29/786, G09F 9/00, G09F 9/30, H01L 21/28, H01L 21/336, H01L 29/417, H01L 51/05

(54) **THIN-FILM TRANSISTOR AND METHOD FOR PRODUCING SAME**

(30) Priority: 29.10.2014 JP 2014220597
(71) Applicant: Toppan Printing Co., Ltd., Tokyo 110-0016 (JP)
(72) Inventor: IKEDA, Noriaki, Tokyo (JP)
(74) Representative: Cabinet Plasseraud
(86) International application number: PCT/JP2015/005385
(87) International publication number: WO 2016/067590

(57) **Abstract**

A thin-film transistor exhibiting good characteristics and a method of fabricating the same is provided for an organic semiconductor thin-film transistor having a semiconductor layer formed by wet film deposition such as printing. The thin-film transistor has at least a gate electrode, a gate insulating layer, a source electrode, a drain electrode, a semiconductor layer connected to the source electrode and the drain electrode, and a protective layer, which are provided on a first substrate. Surfaces of the source electrode and the drain electrode have asperities.

## Description

### [Technical Field]

The present invention relates to a thin-film transistor and a method of fabricating the same.

### [Background Art]

Thin-film transistors are widely used in display devices, including liquid crystal display devices (LCDs), organic electroluminescent (EL) display devices, and electronic paper display devices, and various sensors.

Semiconductor materials dominantly used for thin-film transistors include amorphous silicon, polycrystalline silicon, and oxide semiconductors. In general, thin-film transistors that use such semiconductor materials are fabricated by forming a film by vacuum film deposition, followed by patterning by photolithography or the like.

Organic thin-film transistors which use an organic material as a semiconductor layer are attracting attention in recent years. Organic semiconductor materials have a mobility smaller than that of silicon materials or oxide materials and thus involve difficulty in fabricating a thin-film transistor having high performance. Organic materials, however, have a high degree of freedom in designing the material molecules. Owing to the advancement of technology in recent years, many organic thin-film transistors having a high mobility exceeding the mobility of amorphous silicon have been developed and announced.

In fabricating organic thin-film transistors, wet film deposition is desirably used. Wet film deposition includes a technique of coating/printing using a solution of a semiconductor material, a conductive material, an insulative material, and the like. Use of such wet film deposition enables formation of a device on a plastic substrate at low temperatures and enables manufacture of a device at low cost. Use of printing as the wet film deposition technique enables simultaneous film deposition and patterning, and hence achieves higher material usage efficiency than using vacuum film deposition which is based on a conventionally used photolithography process, without the need of resist pattern forming, etching and peeling. Thus, wet film deposition imposes less load on the environment and therefore is expected to be used in fabricating organic thin-film transistors.

An element structure typically used for the organic thin-film transistors formed by printing is a bottom contact structure in which an organic semiconductor layer is formed on a source electrode and a drain electrode. A higher performance organic thin-film transistor can be obtained by reducing the contact resistance between the semiconductor material and the source electrode or the drain electrode. Methods that may be used for reducing such contact resistance include a method of applying surface treatment to the source electrode and the drain electrode by using a self-assembled monolayer or the like (PTL 1).

When a p-type organic semiconductor material is used, the material is surface-treated using a material, such as a fluorine compound, having electron withdrawing properties.

Typically used organic semiconductor materials include condensed polycyclic aromatic compounds and π-electron polymer materials. Organic semiconductor materials exhibiting high transistor performance (high carrier mobility), however, generally have low solubility in solvents. Thus, an organic semiconductor ink is used in many cases as an ink of low concentration and low viscosity, when used for forming a semiconductor layer with various printing methods, such as ink-jet printing and relief printing, or photolithography.

### [Citation List]

### [Patent Literature]

PTL 1: JP 2012-234923 A

### [Summary of the Invention]

### [Technical Problem]

Accordingly, in an organic thin-film transistor having a bottom contact structure as described above, a surface of a gate insulating layer in a channel region, where the semiconductor layer is formed, has surface properties (surface energy) different from those of the source electrode and the drain electrode. The difference in surface properties leads to a difference in wettability to an organic semiconductor ink, between the surface of the gate insulating layer and the surface of the source electrode or the drain electrode. Thus, an organic semiconductor ink of a low viscosity (0.5 cP to 100 cP), when applied to the transistor, is repelled, causing a failure to form a good pattern of the semiconductor layer.

In particular, when the source electrode and the drain electrode are surface-treated using a fluorine compound, the electrode surfaces will be extremely highly liquid-repellent due to the fluorine compound. Accordingly, wettability to solvents is drastically lowered in the electrode surfaces, making it very difficult to use semiconductor layer wet film deposition that is a method of applying a semiconductor ink by printing or the like to the surface-treated source and drain electrodes.

In light of the matters set forth above, the present invention has as its object to provide a thin-film transistor, particularly, an organic semiconductor thin-film transistor, exhibiting good performance (i.e. which has high carrier mobility), in which a semiconductor layer is formed by wet film deposition, such as printing, and to provide a method of fabricating the same.

### [Solution to Problem]

One aspect of the present invention for solving the above matter is a thin-film transistor comprising at least a gate electrode, a gate insulating layer, a source electrode, a drain electrode, a semiconductor layer connected to the source electrode and the drain electrode, and a protective layer, which are all provided on a substrate, wherein surfaces of the source electrode and the drain electrode each have asperities.

The semiconductor layer may be formed by any of ink jetting, relief printing, planographic printing, and intaglio printing, using a solution in which a semiconductor material or a precursor of the semiconductor material is dissolved.

The surfaces of the source electrode and the drain electrode may each have a portion contacting the semiconductor layer, at least the portion contacting the semiconductor layer having a surface roughness Ra in a range of 3 nm or more to 50 nm or less.

The source electrode and the drain electrode may be formed by any of ink jetting, relief printing, planographic printing, intaglio printing, and screen printing.

The source electrode and the drain electrode may each have a portion contacting the semiconductor layer, at least the portion being made of a metallic material.

The surfaces of the source electrode and the drain electrode may each have a portion contacting the semiconductor layer, at least the portion being surface-treated.

The protective layer may be formed by any of ink jetting, relief printing, planographic printing, intaglio printing, and screen printing, using a solution in which a protective layer material or a precursor of the protective layer material is dissolved or dispersed.

Another aspect of the present invention is a method of fabricating a thin-film transistor comprising a step of successively forming a gate electrode, a gate insulating layer, a source electrode, and a drain electrode on a substrate, a step of forming asperities at surfaces of the source electrode and the drain electrode, a step of applying a semiconductor material to the source electrode, the drain electrode, and a region between the source electrode and the drain electrode to form a semiconductor layer connected to the source electrode and the drain electrode, and a step of forming a protective layer.

Another aspect of the present invention is a method of fabricating a thin-film transistor comprising a step of forming a source electrode and a drain electrode on a substrate, a step of forming asperities at the source electrode and the drain electrode, a step of applying semiconductor material to the source electrode, the drain electrode, and a region between the source electrode and the drain electrode to form a semiconductor layer connected to the source electrode and the drain electrode, and a step of successively forming a gate insulating layer and a gate electrode.

### [Advantageous Effects of Invention]

According to the present invention, when the surfaces of the source electrode and the drain electrode are treated using a material having high liquid-repellent properties, a semiconductor ink can be applied to the surfaces without being repelled. Thus, a thin-film transistor exhibiting good characteristics can be provided for an organic semiconductor thin-film transistor having a semiconductor layer formed by wet film deposition, such as printing.

### [Brief Description of Drawings]

Fig. 1 is a schematic cross-sectional view illustrating a thin-film transistor according to a first embodiment of the present invention.
Fig. 2 is a schematic cross-sectional view illustrating a thin-film transistor according to a second embodiment of the present invention.

### [Description of Embodiments]

Some embodiments of the present invention will hereinafter be described with reference to the drawings. In the following description, components corresponding between the embodiments are designated with the same reference signs to avoid duplicate description.

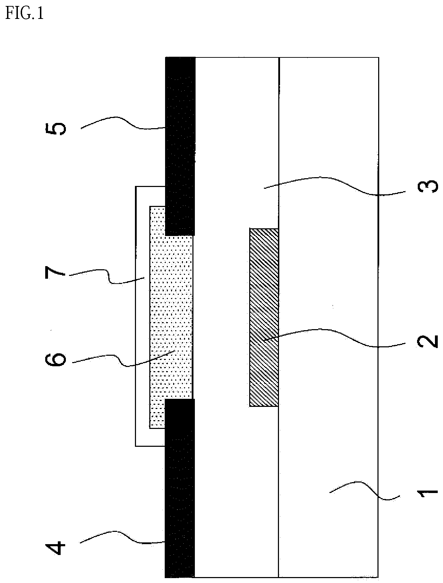

Fig. 1 is a schematic cross-sectional view illustrating a thin-film transistor (of a bottom gate type) according to a first embodiment of the present invention.

The thin-film transistor according to the present embodiment at least includes a gate electrode 2 formed on a substrate 1, a gate insulating layer 3 formed on the gate electrode, a source electrode 4 and a drain electrode 5 formed on the gate insulating layer 3 so as to be spaced apart from each other, a semiconductor layer 6 connected to the source and drain electrodes 4 and 5, and a protective layer 7 for protecting the semiconductor layer 6.

Components used in the present embodiment will hereinafter be described in line with a process of fabricating the thin-film transistor.

Firstly, the gate electrode 2 is formed on the substrate 1. Materials that can be used for the substrate 1 include, but are not limited to, polycarbonate, polyethylene sulfide, polyether sulfone, polyethylene terephthalate, polyethylene naphthalate, cycloolefin polymer, triacetylcellulose, and polyvinyl fluoride films, ethylene-tetrafluoroethylene copolymer resin, weather-resistant polyethylene terephthalate, weather-resistant polypropylene, and glass fiber reinforced acrylic resin films, glass fiber reinforced polycarbonate, polyimide, fluorine resins, cyclic polyolefin resins, glass, silica glass, and the like. These materials may be used alone, or two or more of these materials may be laminated for use as the substrate 1.

When the substrate 1 is an organic film, a transparent gas barrier layer (not shown) can also be formed to improve durability of the thin-film transistor. Gas barrier layers include, but are not limited to, aluminum oxide (Al₂O₃), silicon oxide (SiO), silicon nitride (SiN), silicon oxynitride (SiON), silicon carbide (SiC), and diamond-like carbon (DLC) layers. Two or more of these gas barrier layers can be laminated. The gas barrier layer may be formed only on one surface, or may be formed on both surfaces of the substrate 1 of an organic film. Methods that can be used for forming the gas barrier layer include, but are not limited to, vacuum deposition, ion plating, sputter deposition, laser ablation, plasma CVD (chemical vapor deposition), hot wire CVD, and sol-gel process.

An adhesion layer can also be provided to improve adhesion of the gate electrode 2 formed on the substrate 1 to the substrate 1.

The gate electrode 2, the source electrode 4, and the drain electrode 5 are not required to have clearly define electrode portion and wiring portion, and are referred to, in the present specification in particular, as electrodes as components forming each thin-film transistor. When an electrode does not have to be discriminated from the wiring, the electrode and the wiring in the gate electrode 2, the source electrode 4, or the drain electrode 5 are collectively referred to as a gate, a source, or a drain.

Materials that can be used for the gate electrode 2 include, but are not limited to, metallic materials such as aluminum (Al), copper (Cu), molybdenum (Mo), silver (Ag), chromium (Cr), titanium (Ti), gold (Au), platinum (Pt), tungsten (W), and manganese (Mn), electrically conductive metal oxide materials such as indium oxide (InO), tin oxide (SnO), zinc oxide (ZnO), indium tin oxide (ITO), and indium zinc oxide (IZO), and electrically conductive polymers such as poly(ethylenedioxythiophene)/polystyrenesulfonate (PEDOT/PSS), and polyaniline. These materials may be used singly in a layer, or layers of respective materials may be laminated, or these materials may be alloyed, for use as the gate electrode 2.

The gate electrode 2 can be formed by vacuum film deposition such as vacuum deposition and sputtering, or wet film deposition using a precursor, nanoparticles, or the like of an electrically conductive material. Examples of wet film deposition include, but are not limited to, ink jetting, relief printing, planographic printing, intaglio printing, screen printing, and the like. The gate electrode 2 can be patterned by photolithography, for example, in which pattern forming portions are protected by a resist or the like, and unwanted portions are removed by etching, or can be directly patterned by printing or the like. Patterning methods, however, are not limited to these methods, but well-known and generally-used patterning methods can be used.

Subsequently, the gate insulating layer 3 is formed on the substrate 1 and the gate electrode 2. The gate insulating layer 3 is formed covering at least the gate electrode 2 of the thin-film transistor portion, except for portions of the gate electrode 2 connected to other electrodes or connected to the outside.

Materials that can be used for the gate insulating layer 3 of the present embodiment include, but are not limited to, oxide insulating materials such as silicon oxide (SiOx), aluminum oxide (AlOx), tantalum oxide (TaOx), yttrium oxide (YOx), zirconium oxide (ZrOx), and hafnium oxide (HfOx), silicon nitride (SiNx), silicon oxynitride (SiON), resin materials such as poly acrylates such as polymethyl methacrylate (PMMA), polyvinyl alcohol (PVA), and polyvinyl phenol (PVP), and organic/inorganic hybrid resins such as polysilsesquioxane (PSQ). These materials may be used singly in a layer, or two or more layers of respective materials may be laminated, or the compositions of these materials may be graded in a growth direction, for use as the gate insulating layer 3.

To minimize gate-leakage current of the thin-film transistor, the gate insulating layer 3 preferably has a resistivity of 10¹¹ Ωcm or more, and more preferably 10¹⁴ Ωcm or more.

Methods of forming the gate insulating layer 3 include vacuum film deposition such, as vacuum deposition, ion plating, sputtering, laser ablation, plasma CVD, photo-CVD, and hot wire CVD, and wet film deposition, such as spin coating, die coating, and screen printing. These methods can be used as appropriate according to materials.

Subsequently, the source and drain electrodes 4 and 5 are formed on the gate insulating layer 3. Materials that can be used for the source and drain electrodes 4 and 5 include metallic materials such as aluminum (Al), copper (Cu), silver (Ag), gold (Au), and platinum (Pt), and electrically conductive metal oxide materials such as indium oxide (InO), tin oxide (SnO), zinc oxide (ZnO), indium tin oxide (ITO), and indium zinc oxide (IZO). These materials may be used singly in a layer, or layers of respective materials may be laminated, or these materials may be alloyed, for use as the source electrode 4.

The source and drain electrodes 4 and 5 are preferably formed by wet film deposition using a precursor, nanoparticles, or the like of an electrically conductive material. Examples of such wet film deposition include ink jetting, relief printing, planographic printing, intaglio printing, and screen printing. The electrodes 4 and 5 can be patterned using photolithography, for example, in which pattern forming portions are protected by a resist or the like, and unwanted portions are removed by etching, or can be patterned directly by printing or the like. Patterning methods, however, are not limited to these methods.

The semiconductor layer 6 can be formed on the source and drain electrodes 4 and 5 by wet film deposition using a solution, paste, or the like in which the semiconductor material is dissolved and dispersed. When wet film deposition is used, the surfaces of the source and drain electrodes 4 and 5 are ensured to have fine asperities to thereby reduce repellence of the source and drain electrodes 4 and 5 to the semiconductor material. The surface asperities can be of any size and shape as long as the surfaces are imparted with wettability high enough to reduce repellence to the semiconductor material. The surface roughness or the like may be determined as appropriate according to the viscosity or the like of the semiconductor material. A reference example will be provided below.

The source and drain electrodes 4 and 5 have portions contacting the semiconductor layer 6. When at least these portions have an arithmetic mean roughness Ra (hereinafter referred to as surface roughness) of preferably in the range of 3 nm or more to 50 nm or less, more preferably 12 nm or more to 40 nm or less, and most preferably 15 nm or more to 30 nm or less, the semiconductor layer 6 achieves good adhesion with the source and drain electrodes 4 and 5. If the surface roughness Ra exceeds 50 nm, the wiring resistance may be lowered due to the unevenness of the film thickness, but if smaller than 3 nm, the semiconductor layer 6 homogeneously containing a semiconductor material is not necessarily formed on the surfaces of the source and drain electrodes 4 and 5.

The fine asperities formed on the surfaces of the source and drain electrodes 4 and 5 will provide a good coating film with good adhesion, on condition that the asperities have a mean periodicity (pitch) of convexity and concavity in the range of 20 nm or more to 500 nm or less, and a mean height (height of convexity or depth of concavity) in the range of 20 nm or more to 200 nm or less. With the source and drain electrodes 4 and 5 being imparted with surface asperities, adhesion of the protective layer 7 is similarly enhanced.

The mean periodicity (pitch) of the surface asperities is determined by measuring a distance between adjacent convexities or concavities at 50 or more optionally selected spots in an optionally selected measurement region, and calculating an average of the distances. The mean height of the surface asperities is determined by measuring a distance between a highest point of a convexity and a lowest point of the adjacent concavity at 50 or more optionally selected spots in an optionally selected measurement region, and calculating an average of the distances.

The surface roughness may be controlled by forming a smooth film, followed by etching, such as wet etching, to achieve a desired surface roughness, or may be controlled by dry etching, such as plasma etching or sputter etching, or may be controlled using such a process as corona treatment or atmospheric pressure plasma treatment. Alternatively, the surface shape of the printing plate or the electrode pattern for the electrode material may be controlled so that a desired surface roughness is obtained in forming the source and drain electrodes 4 and 5. Alternatively, if the source and drain electrodes 4 and 5 are formed using a precursor, nanoparticles, or the like of a conductive material, the size of the precursor or the nanoparticles for the source and drain electrodes 4 and 5 may be adjusted to control the surface roughness in heat treatment or the like in forming the source and drain electrodes 4 and 5. Surface roughness may be controlled in any way, not being limited to the methods mentioned above. Surface roughness can be measured using a measuring machine, such as an atomic force microscope (AFM).

The source and drain electrodes 4 and 5, when formed with the semiconductor layer thereon, preferably have a surface area ratio in the range of 1.05 or more to 1.3 or less. The surface area ratio S_{Ratio} is a ratio (S/S₀) of an actually measured surface area S to an area So whose measured surface is ideally flat. If the surfaces of the source and drain electrodes 4 and 5 each have a surface area ratio in the range of 1.05 or more to 1.3 or less, repellence or wet-spread exhibited on the source and drain electrodes 4 and 5 to the semiconductor material can be minimized when the semiconductor material is used for forming the semiconductor layer 6. The surface area ratio can be measured using a measuring machine, such as an atomic force microscope.

The surfaces of the source and drain electrodes 4 and 5 may be surface-treated to decrease contact resistance to the semiconductor material used for the semiconductor layer 6. The surface treatment is preferably performed with respect to at least portions of the electrode surface, which are in contact with the semiconductor layer. Methods of surface treatment that can be favorably used include a method, for example, used for forming a self-assembled monolayer (SAM), in which a surface treatment material chemically reacts with the source and drain electrodes 4 and 5.

Subsequently, the semiconductor layer 6 is formed to establish connection to the surfaces of the gate insulating layer 3, and the source and drain electrodes 4 and 5. Materials that can be used for the semiconductor layer 6 include, but are not limited to, low molecular-weight organic semiconductor materials such as pentacene, tetracene, phthalocyanine, perylene, thiophene, benzodithiophene, anthradithiophene, and derivatives thereof, carbon compounds such as fullerene and carbon nanotubes, and high-molecular-weight organic semiconductor materials such as polythiophene, polyallylamine, fluorene-bithiophene copolymer, and derivatives thereof.

In forming the semiconductor layer 6, wet film deposition is preferably used by using a solution, paste, or the like in which a semiconductor material or a precursor of the semiconductor material is dissolved and dispersed. Examples of wet film deposition include, but are not limited to, ink jetting, relief printing, planographic printing, intaglio printing, and screen printing. Generally known methods can be used.

Subsequently, the protective layer 7 is formed on the semiconductor layer 6. The protective layer 7 is formed to protect the semiconductor layer 6. The protective layer 7 needs to be formed covering at least a region of the semiconductor layer 6, which serves as a channel portion.

Materials for the protective layer 7 include, but are not limited to, inorganic materials such as silicon oxide, aluminum oxide, tantalum oxide, yttrium oxide, hafnium oxide, hafnium aluminate, zirconium oxide, and titanium oxide, and insulating materials such as poly acrylates such as PMMA (polymethyl methacrylate), PVA (polyvinyl alcohol), PVP (polyvinyl phenol), and a fluorine resin.

The material for the protective layer 7 desirably has a resistivity of 10¹¹ Ωcm or more, and more preferably 10¹⁴ Ωcm or more, to minimize leakage current of the thin-film transistor.

The protective layer 7 is formed by any of ink jetting, relief printing, planographic printing, intaglio printing, and screen printing, using a solution in which a protective layer material or its precursor is dissolved or dispersed. The protective layer 7 may be used as a single layer, or may be used as a layer in which two or more layers are laminated. Alternatively, the protective layer 7 may contain a composition graded toward a growth direction.

As described above, the method of fabricating the thin-film transistor according to the first embodiment includes a step of successively forming a gate electrode, a gate insulating layer, and a source electrode and a drain electrode on a substrate, a step of forming asperities in surfaces of the source electrode and the drain electrode, and a step of successively forming a semiconductor layer and a protective layer.

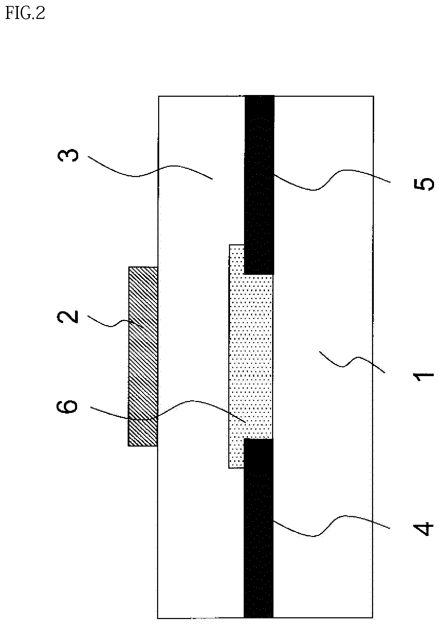

Fig. 2 shows a schematic cross-sectional view of a thin-film transistor (of a top gate type) according to a second embodiment of the present invention. Components corresponding to those of the thin-film transistor of the first embodiment are designated with the same reference signs to omit description as appropriate.

The method of fabricating a thin-film transistor of the present embodiment includes a step of forming a source electrode and a drain electrode on a substrate, a step of forming asperities in the source electrode and the drain electrode, and a step of successively forming a semiconductor layer, a gate insulating layer, and a gate electrode.

### [Examples]

As an example of the present invention, the thin-film transistor shown in Fig. 1 was prepared.

As the substrate 1, non-alkali glass with a thickness of 0.7 mm was used. A Mo alloy was deposited on the glass substrate by DC magnetron sputtering to form a film with a thickness of 200 nm, and the film was patterned into a desired shape by photolithography. Specifically, a positive-type photosensitive photoresist was applied to the film, followed by mask exposure and development with an alkaline developer, thereby forming a resist pattern with a desired shape. The resist pattern was etched with an etching liquid to dissolve unwanted Mo alloy. Then, the photoresist was removed using a resist stripping liquid to form a Mo-alloy electrode with a desired shape, thereby forming a gate electrode 2.

Then, an acrylic resin was applied to the gate electrode 2 by die coating, followed by baking at 230°C to form a gate insulating layer 3 with a thickness of 1 µm.

Then, an ink in which silver nanoparticles were dispersed was applied to the gate insulating layer 3 by ink jetting to obtain pattern shapes of a source electrode 4 and a drain electrode 5, followed by baking at 200°C for 1 hour. The source and drain electrodes 4 and 5 were each ensured to have a thickness of 100 nm. Then, the surface roughness of the source and drain electrodes 4 and 5 was measured with AFM, which revealed that the surface roughness was 4.5 nm in terms of Ra. The silver nanoparticles used herein had a size and concentration which had been adjusted such that the source and drain electrodes 4 and 5 would have a surface roughness of a desired value.

The source and drain electrodes 4 and 5 were surface-treated by immersing the substrate for 30 minutes in isopropyl alcohol in which pentafluorobenzenethiol was dissolved at a concentration of 10 mM. To remove unwanted pentafluorothiophenol, the substrate was cleaned with isopropyl alcohol, followed by drying.

Subsequently, using flexographic printing, a semiconductor ink obtained by dissolving 6,13-bis(triisopropylsilylethynyl)pentacene in tetralin at a concentration of 2 wt% was applied to the surface-treated source and drain electrodes 4 and 5. The semiconductor ink was applied without being repelled by the source and drain electrodes 4 and 5. Then, the semiconductor ink was dried at 100°C to form the semiconductor layer 6.

A fluorine resin was applied to the semiconductor layer 6 by flexographic printing, followed by drying at 100°C to obtain a protective layer 7.

### (Comparative Example)

As a comparative example, a thin-film transistor described below was prepared.

Non-alkali glass with a thickness of 0.7 mm was used as a substrate 1. A Mo alloy was deposited on the glass substrate by DC magnetron sputtering to form a film with a thickness of 200 nm, and the film was patterned into a desired shape by photolithography. Specifically, a positive-type photosensitive photoresist was applied to the patterned film, followed by mask exposure and development with an alkaline developer to form a resist pattern having a desired shape. Then, the resist pattern was etched with an etching liquid to dissolve unwanted Mo alloy. Then, the photoresist was removed using a resist stripping liquid and to form a Mo-alloy electrode having a desired shape, thereby obtaining a gate electrode 2.

Subsequently, an acrylic resin was applied to the gate electrode 2 by die coating, followed by baking at 230°C to form a gate insulating layer 3 with a thickness of 1 µm.

Then, silver was deposited by electron beam vacuum deposition using a metal mask to form a film, thereby forming a source electrode 4 and a drain electrode 5. The source and drain electrodes 4 and 5 were each ensured to have a thickness of 100 nm, as in the example. The source and drain electrodes 4 and 5 of the present comparative example had a surface roughness of 1.5 nm, which was taken to be approximately smooth.

The source and drain electrodes 4 and 5 were surface-treated by immersing the substrate for 30 minutes in isopropyl alcohol in which pentafluorobenzenethiol was dissolved at a concentration of 10 mM. To remove unwanted pentafluorothiophenol, the substrate was cleaned with isopropyl alcohol, followed by drying

Subsequently, a solution obtained by dissolving 6,13-bis(triisopropylsilylethynyl)pentacene in tetralin at a concentration of 2 wt% was applied to the source and drain electrodes 4 and 5 by ink jetting, followed by drying at 100°C, thereby forming a semiconductor layer 6.

A fluorine resin was applied to the semiconductor layer 6 by ink jetting, followed by drying at 100°C, thereby obtaining a protective layer 7.

In the thin-film transistor described in the comparative example, when the semiconductor layer 6 was printed, the surfaces of the source and drain electrodes 4 and 5 exhibited poor wettability against the semiconductor ink because the source and drain electrodes 4 and 5 had been surface-treated for providing high liquid-repellent properties. Therefore, the semiconductor ink was repelled, causing a failure in uniform coating. Consequently, the semiconductor layer 6 could not be connected to or could not be sufficiently connected to the source and drain electrodes 4 and 5, and failed to achieve a function as a thin-film transistor. Moreover, 100 elements of the thin-film transistors described in the comparative example were formed, as samples, on a substrate to measure transistor characteristics of the samples. As a result of the measurements, some elements had insufficient connection between the semiconductor layer 6 and the source electrode 4 or the drain electrode 5. Thus, variation was observed in transistor characteristics among the elements.

In the example of the present invention, since the surfaces of the source and drain electrodes 4 and 5 had fine asperities, even if the surfaces of the source and drain electrodes 4 and 5 were surface-treated using a material having high liquid-repellent properties, the semiconductor ink could be applied without being repelled, and the semiconductor layer 6 was well connected to the source and drain electrodes 4 and 5. Thus, it was confirmed that a thin-film transistor exhibiting good characteristics was formed. Moreover, 100 elements of the thin-film transistors described in the example were formed, as samples, on a substrate to measure transistor characteristics of the samples. As a result of the measurements, all of the elements established sufficient connection of the semiconductor layer 6 to the source and drain electrodes 4 and 5, and no variation was observed in transistor characteristics among the elements.

### [Industrial Applicability]

The present invention is useful to thin-film transistors, and thus is useful, for example, to display devices such as a liquid crystal display device (LCD), an organic electroluminescent (EL) display device, and an electronic paper display device, and various sensors, and the like.

### [Reference Signs List]

1: substrate, 2: gate electrode, 3: gate insulating layer, 4: source electrode; 5: drain electrode, 6: semiconductor layer, 7: protective layer.

## Claims

1. A thin-film transistor comprising at least a gate electrode, a gate insulating layer, a source electrode, a drain electrode, a semiconductor layer connected to the source electrode and the drain electrode, and a protective layer, which are all provided on a substrate, wherein surfaces of the source electrode and the drain electrode each have asperities.

2. The thin-film transistor according to claim 1, wherein the semiconductor layer is formed by any of ink jetting, relief printing, planographic printing, and intaglio printing, using a solution in which a semiconductor material or a precursor of the semiconductor material is dissolved.

3. The thin-film transistor according to claim 1 or 2, wherein the surfaces of the source electrode and the drain electrode each have a portion contacting the semiconductor layer, at least the portion contacting the semiconductor layer having a surface roughness Ra in a range of 3 nm or more to 50 nm or less.

4. The thin-film transistor according to any one of claims 1 to 3, wherein the source electrode and the drain electrode are formed by any of ink jetting, relief printing, planographic printing, intaglio printing, and screen printing.

5. The thin-film transistor according to any one of claims 1 to 4, wherein the source electrode and the drain electrode each have a portion contacting the semiconductor layer, at least the portion being made of a metallic material.

6. The thin-film transistor according to any one of claims 1 to 5, wherein the surfaces of the source electrode and the drain electrode each have a portion contacting the semiconductor layer, at least the portion being surface-treated.

7. The thin-film transistor according to any one of claims 1 to 6, wherein the protective layer is formed by any of ink jetting, relief printing, planographic printing, intaglio printing, and screen printing, using a solution in which a protective layer material or a precursor of the protective layer material is dissolved or dispersed.

8. A method of fabricating a thin-film transistor, comprising a step of successively forming a gate electrode, a gate insulating layer, a source electrode, and a drain electrode on a substrate, a step of forming asperities at surfaces of the source electrode and the drain electrode, a step of applying a semiconductor material to the source electrode, the drain electrode, and a region between the source electrode and the drain electrode to form a semiconductor layer connected to the source electrode and the drain electrode, and a step of forming a protective layer.

9. A method of fabricating a thin-film transistor comprising a step of forming a source electrode and a drain electrode on a substrate, a step of forming asperities at the source electrode and the drain electrode, a step of applying semiconductor material to the source electrode, the drain electrode, and a region between the source electrode and the drain electrode to form a semiconductor layer connected to the source electrode and the drain electrode, and a step of successively forming a gate insulating layer and a gate electrode.
